# EUROPEAN PATENT APPLICATION

(11) **EP 2 474 927 A1**
(43) Date of publication of application: **11.07.2012**
(21) Application number: 10197104.2
(22) Date of filing: 28.12.2010
(51) Int. Cl.: G06F 17/50

(54) **Method of layout verification of the integrated circuits**

(71) Applicant: POLYTEDA Software Corporation Limited, 3105 Limassol (CY)
(72) Inventor: Marchuk, Volodymyr, Toronto Ontario M6S1Z3 (CA); Kornachevskyy, Yaroslav, 02140 Kyiv (UA)
(74) Representative: Benatov, Emil Gabriel

(57) **Abstract**

The method is used during the development of the layout of integrated circuits and works and performs the following operations on the figure 1. The imperfection of the given method of layout verification of the integrated circuits is the following: it is not always possible to provide the best (or close to that) performance, as there's no separate partition configuration for every single operation, according to the parameters of the operations and layers that take part in such operations, accordingly, not for all the operations and the operation sets the computing process will be performed in the optimal mode. Moreover, the geometrical data for the layers (that are read from the nearby interacting partitions into the current computing partition) are obtained in the initial form. That leads to the additional time consumption for the processing.

## Description

### FIELD OF THE INVENTION

The method of layout verification of the integrated circuits is used during the development of the layout of integrated circuits.

### BACKGROUND OF THE INVENTION

There is known a method of layout verification of the integrated circuits [US7617464B2] that is used for the parallel processing of the layout of integrated circuits during the physical verification or the similar design tasks. For this purpose the layout is split into numerous two-dimensional "partitions". Such partitions can correspond to the rectangular layout area. The partition can be a layout that is organized hierarchically, and may contain many layers. In the alternative embodiments, partition may consist of one or more not-rectangular figures or itself it can be not-rectangular. Some or all of the partitions can be parallel processed by different processing entities. Parallelism could be implemented by the processing of some or all partitions with the different processing entities. The sequence of actions: The layout is split into two or more partitions. The size of the configuration and the location of partitions can be chosen according to the user's needs in performance (processing speed), and also the parameters of planning, the parameters of the computing system, the set of heuristics and other settings, that are not planned by the user. In some embodiments - the partitions can have different size. In the alternative embodiments - all or some of the partitions may have the same size. Also the interactions between the partitions can be defined. The interaction depends on the type of the operation performed and the topological data that are used in the computing partition from the other partitions in order to complete the operation. In the analyzed method we use the classification of operations of 4 (four) types according to the required topological data:
- The operations that do not need the data from other partitions;
- The operation needs data from the nearby partitions to be performed (usually the limited interaction between the partitions is used);
- The operation that requires access to the global data (for example to calculate the square of the layer figures);
- The operations requires access to the all of the described cases (combination);

One of the methods of defining the interaction between partitions is in finding the "HALO" around every partition - that is interacting with other partitions. The halo can be defined for each partition separately or can be common for every or all partitions.

After the generations of the partitions, there can be performed trial processing of some partitions in order to analyze the performance for each separate layout partition configuration and to correct the partitions (changing the partitions' configuration). After the definition of the partitions' configuration and interactions between them, all or some partitions could be processed in parallel mode to perform the layout operation.

The imperfection of the given method of layout verification of the integrated circuits is the following: it is not always possible to provide the best (or close to that) performance, as there's no separate partition configuration for every single operation, according to the parameters of the operations and layers that take part in such operations, accordingly, not for all the operations and the operation sets the computing process will be performed in the optimal mode. Moreover, the geometrical data for the layers (that are read from the nearby interacting partitions into the current computing partition) are obtained in the initial form. That leads to the additional time consumption for the processing. Such consumption is especially noticeable during the operations with greater halo.

### SUMMARY OF THE INVENTION

The task of invention is to increase the speed of the layout verification.

This task can be solved the following way: the actions are performed - 1 to read the layout and generate the list of tasks, 5 to read the processing data for the partition Pᵢ from the data base DB and also to perform 8 to read the data from the nearby partitions and to join with the data in the current Pᵢ , 9 to perform according to the task the processing of the data for the partition Pᵢ, 10 separate the data the processing of which have been accomplished from the data that require joining with the data from the rest of partitions, 11 to save the ready data of the partition Pᵢ into the DB, from the action 10, 2 to obtain the data from the processed partitions from P₀ to Pᵢ₋₁ that needs joining, 13 to join the data of the current partition Pᵢ that are obtained in the action 10 - to separate the data, processing of which have been accomplished from the data that needs to be joined with the one from the rest of partitions, and the data from the nearby partitions from P₀ to Pᵢ₋₁ that are obtained in the 12, notably - to obtain the data from the processed partitions from P₀ to Pᵢ₋₁ that require joining, 14 - to choose the output data of the partition Pᵢ, that can be potentially required for the joining with the other partitions from Pᵢ₋₁ to P_{N} and 15 - to save the rest of the processed data of the partition Pᵢ into the DB. The actions are performed by-turn starting 1 - to read the layout and to generate the list of tasks and to perform sequentially the following operations: 2 - to chose the next task from the list, 3 - according to the task define the quantity and the size of the partitions, to generate the partitions from the P₀ to P_{N} and to define the order of their processing, 4 - to choose the next one, according to 3, notably - according to the task to define the quantity and the size of the partitions, to generate the partitions from P₀ to P_{N} and to define the order of their processing, the partition Pᵢ, 5 - to read the processing data for the partition Pᵢ from the DB, 6 to convert the data into the inner data representation format, 7 - to define in the partition Pᵢ the data, that are required for the processing of the next partitions, to save these data into the Pᵢ partition data container, 8 - to read the data from the processed earlier nearby partitions from P₀ to Pᵢ₋₁ and to join the data with the current Pᵢ, 9 - to perform the processing for the partition Pᵢ according to the task, 10 - to separate data the processing of which have been accomplished from the one requires joining with the data from the rest of the partitions, 11 - to save the ready data from the partition Pᵢ into the DB, obtained from the 10, notably to separate the data processing of which have been accomplished from the one requires joining with the data from the rest of the partitions, 12 to obtain the data that require joining from the processed partitions from P₀ to Pᵢ₋₁, 13 - to join the data of the current partition Pᵢ , obtained in 10, notably to separate the data the processing of which have been accomplished from the one requires joining with the data from the rest of the partitions and the data from the nearby partitions from P₀ to Pᵢ₋₁, obtained in 12, notably to obtain the data that require joining form the processed partitions from P₀ to Pᵢ₋₁. 14 - to choose the output data of the partition Pᵢ, that potentially can be required for the joining with the other partitions from Pᵢ₊₁ to P_{N} and 15 - to save the left processed data of the partition Pᵢ to the DB. After this there is a check 16 - if there are some unprocessed partitions, and if yes - the cycle is repeated from the 4 - to chose the next, according to 3, notably - according to the task - to define the size and the quantity of the partitions, to generate the partitions from P₀ to P_{N} and to define the order of their processing, partition Pᵢ. If no - the following check 17 is performed - to check if there are some unprocessed tasks, of yes - the cycle is repeated from 2 - chose the following task from the list, if no - the layout verification of the integral circuit is complete.

### BRIEF DESCRIPTION OF THE DRAWING

More detailed the method of layout verification of the integrated circuits is shown on the graphic, where:

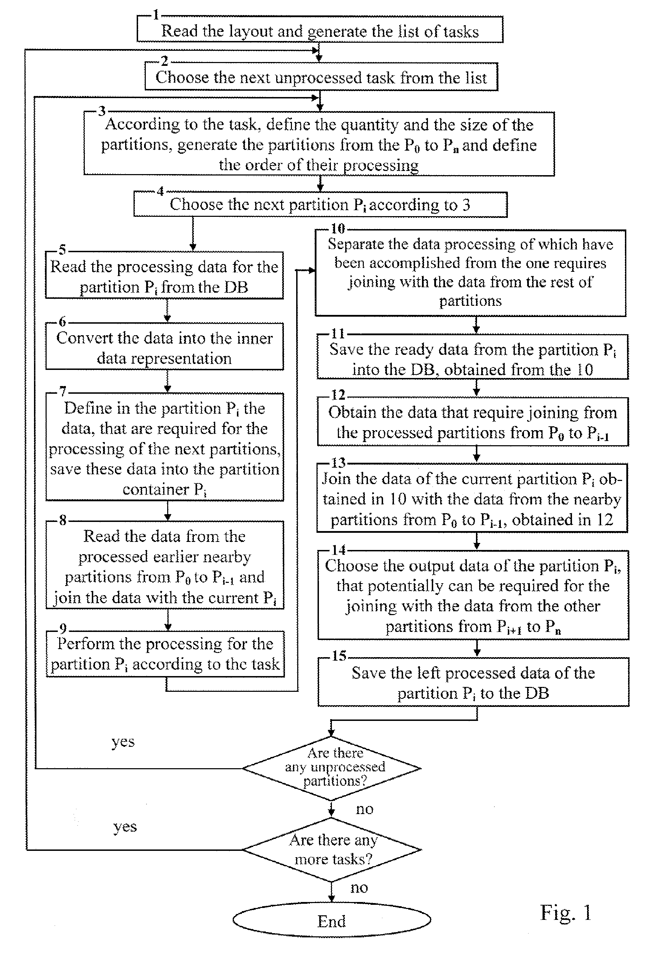

- Fig. 1 contains the method of layout verification of the integrated circuits in the algorithmic form;
- Fig. 2 illustrates the possible separation into partitions;
- Fig. 3 illustrates the certain halo determination;

### DETAILED DESCRIPTION OF A PREFERENTIAL EMBODIMENT

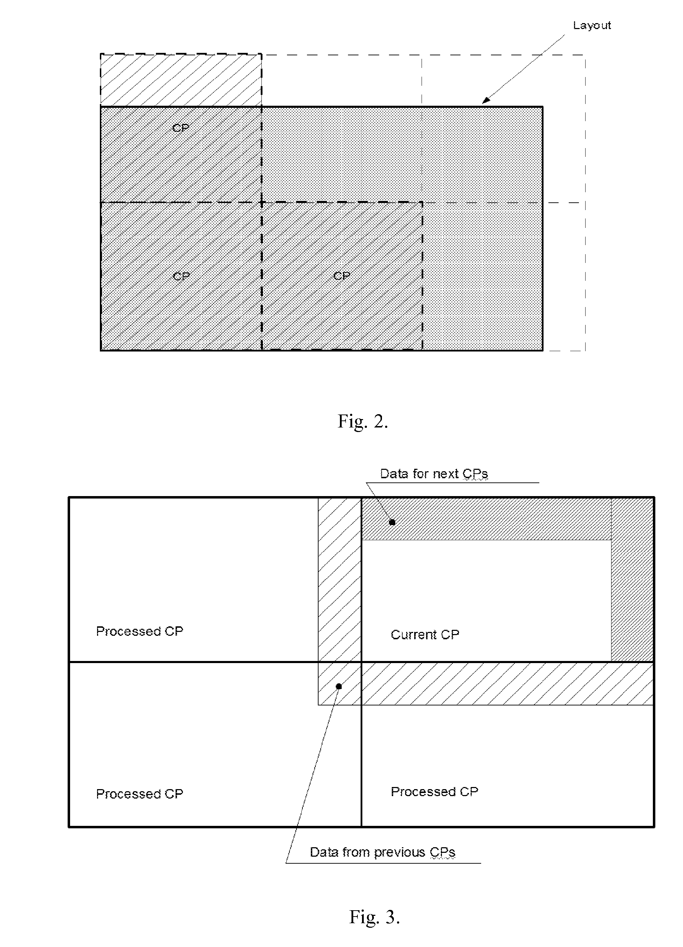

The method of layout verification of the integrated circuits performs the following sequence of operations.
1. The layout is red and the list of tasks is generated. Each task is an operation or the set of operations that are required to be performed on the set of layers. The output data of the operation can be: the new topological layer, that can be stored to the data base the table of parameters, text report, the random combination of the above-listed. The tasks are performed sequentially, but it is possible that tasks will be performed in the parallel mode;
2. The next unprocessed task is chosen from the list;
3. According to the task it defines the quantity and the size of the partitions, then partitions from P₀ to P_{N} are generated (fig.2) and the order of their processing is defined. The free order of the partitions' processing is allowed. The partitions can be of random size. The size of the processed partitions is chosen according to the density of the input layers and the type of the operations performed in the given task. Choosing the size of the partitions we factor into the architecture of the computing system, that will perform the task, particularly the features of the operating memory sub-system, including the processor's cash-memory. The partitions must fully cover the layout. The parallel execution of tasks while the partitions' processing is allowed;
4. The next (according to the 3) partition Pᵢ is chosen;
5. The data that should be processed for the partition Pᵢ are read from the DB
6. The data is converted from the format of the DB into the inner data representation that provides the rapidity of the performance;
7. In the partition Pᵢ the data, required for the processing of the next partition is defined. These data are stored in the container of partition Pᵢ. Choosing of this data is the key factor in providing the processing speed of the layout. The data is chosen according to the fig.3, notably - on the partition's boundary - (the halo). The size of the halo is defined by the need of the performed operations of geometrical data processing. And, according to the operation (s) (required for it\them data), the data of the whole partition can be stored into container. Besides, if needed - the data can be stored from the boundary only (the size of the halo is 0, but there are some geometrical objects touching the edge), or not stored at all (no halo, and the information about the edge is not needed);
8. The data from the nearby partitions is read (obtained in the 7 during the processing of the previous partitions) and joined with the data in the current partition Pᵢ;
9. Processing of the data for the partition Pᵢ according to the performed task;
10. The data, processing of which have been accomplished is separated from the data that needs to be joined with the data from the rest of partitions;
11. The ready data from the partition Pᵢ are stored into the DB ( from the 10);
12. Obtain the data from the partitions from P₀ to P_{N} (obtained in the 14, as they require the further processing), that need to be joined with the data from the current partition
13. The data from the current partition Pᵢ (obtained in 10) are joined with the data from P₀ to Pᵢ₋₁ (obtained in the 12);
14. The output data of the partition Pᵢ is chosen, that can be potentially required for the joining with the data from the other partitions from Pᵢ₊₁ to P_{N};
15. The processed data from the partition Pᵢ that is left - stored into the DB;
16. If there are some unprocessed partitions - the cycle goes back to 4, to continue the processing of the partitions]
17. If there are some unperformed tasks left, the cycle goes back to the 2 - to continue the task processing;

Thereby, the speed of the layout verification is increased.

## Claims

1. The method of layout verification of the integrated circuits follows the next order of operations: (1) read the layout and generate the list of tasks, (5) read the processing data for the partition Pᵢ from the DB and also to perform (8) read the data from the nearby partitions and to join the data with the current Pᵢ, (9) to perform, the processing of the data for the partition Pᵢ according to the task, (10) separate the data processing of which have been accomplished from the data that require joining with the data from the rest of partitions, (11) to save the ready data of the partition Pᵢ into the DB, from the action 10, (12)-to obtain the data that need joining from the processed partitions from P₀ to Pᵢ₋₁, (13) to join the data of the current partition Pᵢ that are obtained in the action (10) - to separate the data, processing of which have been accomplished from the data that needs to be joined with the one from the rest of partitions, and the data from the nearby partitions from P₀ to Pᵢ₋₁ that are obtained in the (12), notably - to obtain the data that require joining from the processed partitions starting P₀ to Pᵢ₋₁, (14) - to choose the output data of the partition Pᵢ, that can be potentially required for the joining with the other partitions from Pᵢ₊₁ to P_{N} and (15) - to save the rest of the processed data of the partition Pᵢ into the DB with the only difference, that all the actions go by-turn - after 1 read the layout and generate the list of tasks, next actions are performed sequentially: (2) chose from the list the next task, (3) according to which, to define the quantity and the size of the partitions, to generate the partitions from P₀ to P_{N} and to define the order of their processing, (4) select the next - according to the action - (3) notably - according to the task, define the quantity and the size of the partitions, to generate the partitions from P₀ to P_{N}, partition Pᵢ, (5) to read the processing data for the partition Pᵢ from the DB, (6) to convert the data into the inner data representation, (7) to define the partition's Pᵢ data, required for processing of the next partition, store this data into the data container of partition Pᵢ, (8) to read the data from the earlier processed partitions P₀ to P₁ and join with the data of current Pᵢ, (9) to perform the processing of the data for the partition Pᵢ according to the task, (10) separate the data processing of which have been accomplished from the data that require joining with the data from the rest of partitions, (11) to save the ready data of the partition Pᵢ into the DB, obtained from the action (10), notably - separate the data processing of which have been accomplished from the data that require joining with the data from the rest of partitions, (12) to obtain the data that needs joining from the processed partitions from P₀ to Pᵢ₋₁, (13) to join the data of the current partition Pᵢ that are obtained in the action (10) - to separate the data processing of which have been accomplished from the data that needs to be joined with the data from the rest of partitions, and the data from the nearby partitions from P₀ to Pᵢ₋₁ that are obtained in the (12), notably - to obtain the data that require joining from the processed partitions starting P₀ to Pᵢ₋₁, (14) to choose the output data of the partition Pᵢ, that can be potentially required for the joining with the other partitions from Pᵢ₊₁ to P_{N} and (15) to save the data that left in the partition Pᵢ to the DB|, and after this there is a check (16) - if there are some unprocessed partitions, and if yes - the cycle is repeated from the (4) - to chose, according to (3), notably - according to the task - to define the size and the quantity of the partitions, to generate the partitions from P₀ to P_{N} and to define the order of their processing, partition Pᵢ, if no - the following check (17) is performed - checking if there are some unprocessed tasks, if yes - the cycle is repeated from (2) - chose the next unprocessed task from the list, if no - the layout verification of the integral circuit is complete.
